# EUROPÄISCHE PATENTSCHRIFT

(11) **EP 1 264 410 B1**
(45) Veröffentlichungstag und Bekanntmachung des Hinweises auf die Patenterteilung: **09.04.2008**
(21) Anmeldenummer: 01910098.1
(22) Anmeldetag: 23.02.2001
(51) Int. Cl.: H04B 1/00

(54) **VORRICHTUNG ZUR LINEARISIERUNG EINES HOCHFREQUENZ-VERSTÄRKERS**
DEVICE FOR LINEARISING A HIGH-FREQUENCY AMPLIFIER
DISPOSITIF POUR LINEARISER UN AMPLIFICATEUR HAUTE FREQUENCE

(30) Priorität: 29.02.2000 DE 10009596
(43) Veröffentlichungstag der Anmeldung: 11.12.2002
(73) Patentinhaber: Ericsson AB, Stockholm (SE)
(72) Erfinder: SCHICK, Michael, 71554 Weissach Im Tal (DE)
(74) Vertreter: Pellkofer, Dieter
(86) Internationale Anmeldenummer: PCT/IB2001/000396
(87) Internationale Veröffentlichungsnummer: WO 2001/065706

(56) Entgegenhaltungen:
- WO-A-99/45640
- US-A- 5 164 678
- US-A- 5 193 224

## Beschreibung

Die vorliegende Erfindung betrifft eine Vorrichtung zur Linearisierung eines Hochfrequenz-Verstärkers mittels eines dem Verstärker vorgeschalteten Vorverzerrers gemäß dem Oberbegriff des Anspruchs.

Beispielsweise werden für die beim digitalen Richtfunk verwendete Modulationsart QAM sehr große Forderungen an die Linearität eines Sendeverstärkers gestellt. Je höher die Anzahl der Modulationsstufen ist, desto höhere Anforderungen sind an die Linearität des Verstärkers zu stellen. Für sehr hohe Modulationsstufen, wie 256- und 512-QAM, ist auch eine hohe Sendeleistung erforderlich, damit bei gleicher Funkfeldlänge ein größerer Signal-Rausch-Abstand erreicht wird. Es ist das Ziel, mit möglichst wenigen Verstärkerstufen auskommen zu können. Deshalb ist man bestrebt, jeden Verstärker möglichst weit auszusteuern, d.h. die Spitzenaussteuerungen bis nahe an den 1dB-Kompressionspunkt heranzuführen. Damit wird der Verstärker nicht nur in seinem linearen, sondern auch in seinem nichtlinearen Bereich betrieben. Um trotzdem im Ausgangssignal des Verstärkers einen genügend großen Intermodulationsabstand zu erreichen, wird die oben angesprochene Linearisierung des Verstärkers vorgenommen. Die Linearisierung eines Hochfrequenzverstärkers mit einem diesem vorgeschalteten Vorverzerrer ist aus der US 4,329,655 bekannt. Diese bekannte Vorrichtung selektiert aus dem Ausgangssignal des Verstärkers ein bestimmtes Frequenzband, das schließlich als Stellgröße für Phasen- und Dämpfungsglieder des Vorverzerrers verwendet wird, um diese so einzustellen, dass die vom Verstärker erzeugten Intermodulationsprodukte möglichst weitgehend kompensiert werden.

Bei einer aus der WO 99/45640 A bekannten Linearisierungsvorrichtung der eingangs genannten Art wird aus dem vom Ausgangssignal des Hochfrequenzverstärkers abgeleiteten Signal ein wesentlicher Teil des Hauptsignals entfernt und ein Interpolationsprodukt bestimmter Ordnung des dadurch gebildeten, einen relativ großen Anteil an im Verstärker erzeugten Störkomponenten enthaltenden Fehlersignals mit einem Referenzstörsignal derselben Ordnung korreliert.

Auch in der US-A-5 193 224 ist eine Vorrichtung zur Linearisierung eines Hochfrequenzverstärkers mittels eines dem Hochfrequenzverstärker vorgeschalteten Vorverzerrers beschrieben. Bei dieser Vorrichtung ist jedoch lediglich eine Kompensation von Phasenverzerrungen vorgesehen.

Der Erfindung liegt die Aufgabe zugrunde, eine Vorrichtung der eingangs genannten Art anzugeben, mit der gegenüber dem Stand der Technik eine weitere Verbesserung bei der Kompensation der vom Hochfrequenz-Verstärker erzeugten Intermodulationsprodukte mittels eines Vorverzerrers erreicht wird.

Die genannte Aufgabe wird mit den kënnzeichnenden Merkmalen des Anspruchs 1 gelöst.

Dadurch, dass die Regelgröße allein durch die Intermodulationsprodukte, welche kompensiert werden sollen, bestimmt wird, und Modulationsanteile des Eingangssignals dabei ohne Einfluß sind, ist eine besonders weitgehende Kompensation von Intermodulationsprodukten und damit Linearisierung des Hochfrequenz-Verstärkers möglich.

Im Signalzweig ist das auch dem Vorverzerrer zugeführte Eingangssignal über ein variables Phasenglied einem ersten Eingang eines Summierers zugeführt und einem zweiten Eingang des Summierers das Ausgangssignals des Verstärkers zugeführt. Des weiteren ist eine automatische Verstärkungsregelung vorgesehen, welche die Pegel der beiden an den Eingängen des Summierers anliegenden Signale aneinander anpaßt. Das Ausgangssignal des Summierers wird zum einen als Regelgröße für das variable Phasenglied im Signalzweig verwendet, das adaptiv so eingestellt wird, dass das Ausgangssignal des Summierers ausschließlich Intermodulationsprodukte enthält. Außerdem wird das Ausgangssignal des Summierers als Regelgröße für die variablen Phasen- und Dämpfungsglieder des Vorverzerrers verwendet.

An den Ausgang des Summierers ist ein logarithmischer Verstärker geschaltet, der das die Intermodulationsprodukte enthaltende Ausgangssignal des Summierers in einer die Regelgröße bildende Gleichspannung wandelt.

Es bringt schaltungstechnische Vorteile, wenn die Ausregelung der Intermodulationsprodukte nicht im Hochfrequenzbereich sondern im Zwischenfrequenzbereich erfolgt. Dazu ist dem Vorverzerrer, dessen Eingangssignal im Zwischenfrequenzbereich liegt, ein Aufwärtsmischer nachgeschaltet, der das vorverzerrte Zwischenfrequenzsignal in die für den Hochfrequenz-Verstärker bestimmte Hochfrequenzebene heraufsetzt. Ein Abwärtsmischer setzt einen vom Verstärkerausgangssignal ausgekoppelten Signalanteil, aus dem die Regelgröße abgeleitet wird, in den Zwischenfrequenzbereich herab.

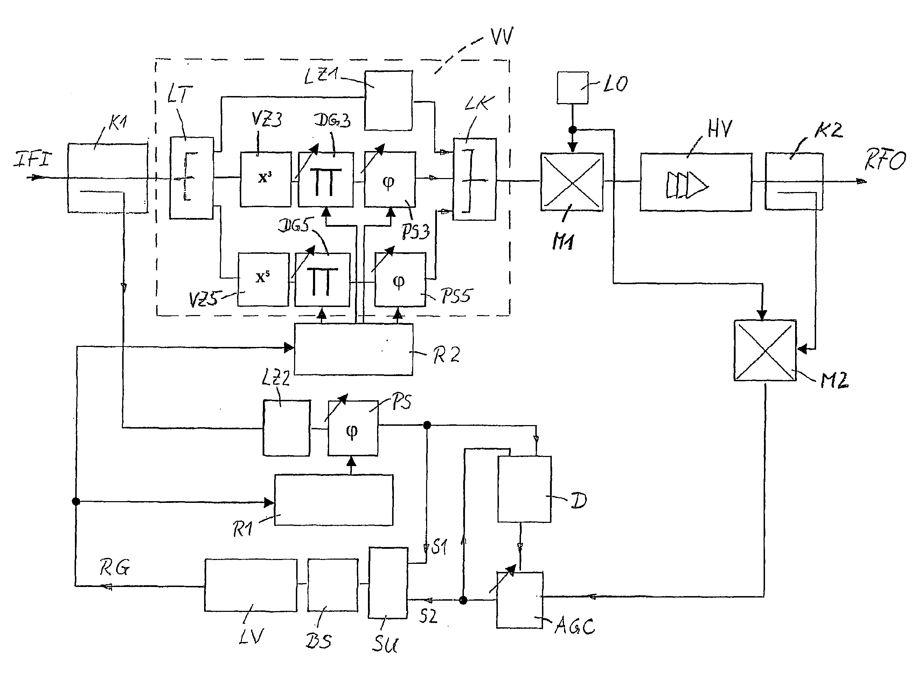

Anhand eines in der Zeichnung dargestellten Ausführungsbeispiels wird nachfolgend die Erfindung näher erläutert.

Die einzige Figur der Zeichnung stellt ein Blockschaltbild zur Linearisierung eines Hochfrequenz-Verstärkers dar.

Um den Hochfrequenz-Verstärker HV, der in der Regel aus mehreren Verstärkungsstufen besteht, zu linearisieren, d. h. die von ihm erzeugten Intermodulationsprodukte zu kompensieren, ist dem Verstärker HV ein Vorverzerrer VV vorgeschaltet. Das dem Vorverzerrer VV zugeführte Eingangssignal IFI, das vom Hochfrequenz-Verstärker HV verstärkt werden soll, liegt in einem Zwischenfrequenzbereich. Nach der Vorverzerrung wird das Zwischenfrequenzsignal IFI von einem Mischer M1 in die für den Hochfrequenz-Verstärker HV bestimmte Hochfrequenzebene heraufgesetzt. Dieser Mischer M1 erhält von einem Lokaloszillator LO seine Referenzfrequenz. Am Ausgang des Hochfrequenz-Verstärkers HV liegt dann das verstärkte Hochfrequenz-Ausgangssignal RFO an.

Der Vorverzerrer VV besteht in bekannter Weise (vergleiche z.B. US 4,329,655) aus mehreren parallelen Zweigen, auf die mittels eines Leistungsteilers LT das Eingangssignal IFI aufgeteilt wird. Die Ausgangssignale der drei Zweige werden einander von einem Leistungskombinierer LK zu einem gemeinsamen, dem Aufwärtsmischer M1 zugeführten Ausgangssignal überlagert. Ein erster Zweig des Vorverzerrers VV besitzt ein Verzerrungsglied VZ3 dritten Grades, ein variables Dämpfungsglied DG3 und ein variables Phasenglied PS3. Ein zweiter Zweig des Vorverzerrers VV besitzt ein Verzerrungsglied VZ5 fünften Grades und ebenfalls ein variables Dämpfungsglied DG5 und ein variables Phasenglied PS5. Der dritte Zweig ist mit einem Laufzeitglied LZ1 versehen, welches die Laufzeit des Signals durch diesen Zweig an die Laufzeit der Signale durch die anderen beiden Zweige anpaßt. Abweichend von dem dargestellten Ausführungsbeispiel des Vorverzerrers VV können auch mehr als zwei Zweige mit Verzerrungsgliedern oder auch nur ein Zweig mit einem Verzerrungsglied vorgesehen werden. Außerdem können Verzerrungsglieder ungerader oder auch gerader Ordnung eingesetzt werden.

Am Eingang des Vorverzerrers VV befindet sich ein Koppler K1, über den ein Teil des Eingangssignals IFI ausgekoppelt und einem Signalzweig mit einem Laufzeitglied LZ2 und einem variablen Phasenglied PS zugeführt wird. Der Ausgang des variablen Phasengliedes PS gelangt an einen ersten Eingang eines Summierers SU. An den zweiten Eingang dieses Summierer SU ist ein Signalanteil, der mittels eines Kopplers K2 vom Ausgangssignal des Hochfrequenz-Verstärkers HV ausgekoppelt wird und von einem Abwärtsmischer M2 von der Hochfrequenzebene in die Zwischenfrequenzebene herabgesetzt wird. Der Abwärtsmischer M2 erhält seine Referenzfrequenz ebenfalls aus dem Lokaloszillator LO und setzt das Hochfrequenz-Ausgangssignal in die gleiche Zwischenfrequenzebene um, in der sich das Eingangssignal IFI befindet.

Die beiden an den Eingängen des Summierers SU anliegenden vom Signalzweig LZ2, PS und vom Ausgangssignal des Hochfrequenz-Verstärkers HV abgeleiteten Signale S1 und S2 werden einem Schaltblock D zugeführt, in dem durch Gleichrichtung die Pegel beider Signale S1 und S2 bestimmt werden und die Differenz der beiden Signalpegel gebildet wird. Das Ausgangssignal des Schaltblocks D steuert einen regelbaren Verstärker AGC, über den das vom Ausgangssignal RFO des Hochfrequenz-Verstärkers HV abgeleitete Signal S2 geführt wird. Und zwar wird der regelbare Verstärker AGC bezüglich seiner Verstärkung so eingestellt, dass die beiden Eingangssignale S1 und S2 des Summierers SU gleiche Pegel besitzen. Die Wirkung davon ist, dass das Ausgangssignal des Summierers SU ausschließlich die vom Hochfrequenz-Verstärker HV erzeugten Intermodulationsprodukte enthält. Das Signal S2 weist nämlich sowohl Spektralanteile der Intermodulationsprodukte als auch Spektralanteile des modulierten Eingangssignals IFI auf. Das Signal S1 enthält nur Spektralanteile des Eingangssignals IFI. Nachdem beide Signale S1 und S2, wie beschrieben, auf gleiche Pegel eingeregelt worden sind, löschen sich die in den beiden Signalen S1 und S2 vorhandenen Spektralanteile des Eingangssignals IFI gegenseitig aus, so dass im Ausgangssignal des Summierers SU ausschließlich Spektralanteile der Intermodulationsprodukte übrig bleiben. Das Ausgangssignal des Summierers SU wird über ein Bandsperrfilter BS und einen logarithmischen Verstärker LV geführt. Das Bandsperrfilter BS unterstützt die Selektion der Spektralanteile der Intermodulationsprodukte. Der logarithmische Verstärker LV, der vorzugsweise eine große Dynamik aufweist, wandelt das Ausgangssignal des Summierers in eine Gleichspannung RG um.

Das vom logarithmischen Verstärker LV erzeugte Gleichspannungssignal RG, das ausschließlich von den Intermodulationsprodukten abhängt, dient zum einen als Regelgröße für das variable Phasenglied PS im Signalzweig, welcher aus dem Ausgangssignal IF1 einen Signalanteil S1 dem Summierer SU zuführt. Ein Regler R1 regelt in Abhängigkeit von der Regelgröße RG das variable Phasenglied PS so, dass sich bei der Summation der beiden Signale S1 und S2 die darin vorhandenen Spektralanteile des Eingangssignals FI1 gegenseitig vollständig auslöschen und nur noch die reinen Intermodulationsprodukte im Ausgangssignal des Summierers SU übrig bleiben.

Des weiteren wird die Regelgröße RG einem zweiten Regler R2 zugeführt. Dieser zweite Regler R2 steuert in Abhängigkeit von der Regelgröße RG die Dämpfungsglieder DG3, DG5 und Phasenglieder PS3 und PS5 im Vorverzerrer VV so, dass die durch die Regelgröße RG repräsentierten Intermodulationsprodukte minimal werden. Auf diese Weise werden durch die Vorverzerrung Intermodulationsprodukte, die durch den Betrieb des Hochfrequenz-Verstärkers HV im nicht linearen Bereich entstehen, in hohem Maße kompensiert, so dass das Intermodulationsrauschen im verstärkten Hochfrequenz-Ausgangssignal RFO minimal wird.

## Patentansprüche

1. Vorrichtung zur Linearisierung eines Hochfrequenz-Verstärkers mittels eines dem Verstärker (HV) vorgeschalteten Vorverzerrers (VV), mit einen Regler (R2) umfassenden Schaltmitteln zur adaptiven Steuerung eines oder mehrerer variabler Phasen- (PS3, PS5) und Dämpfungsglieder (DG3, DG5) des Vorverzerrers (VV) in Abhängigkeit vom Ausgangssignal (RFO) des Verstärkers (HV) zur Minimierung der vom Verstärker (HV) erzeugten Intermodulationsprodukte, einem einen Regler (R1) umfassenden Signalzweig (LZ2, PS, D, AGC, SU, BP, LV, R1) zur Selektion der Intermodulationsprodukte aus dem Verstärkerausgangssignal (RFO) unter Einbeziehung des Eingangssignals (IFI) des Vorverzerrers (VV) und zur Erzeugung einer durch die Intermodulationsprodukte gebildeten Regelgröße (RG) für die variablen Phasen- (PS3, PS5) und Dämpfungsglieder (DG3, DG5) des Vorverzerrers (VV), wobei im Signalzweig ein über einen Koppler (K1) ausgekoppelter Teil (S1) des dem Vorverzerrer (VV) zugeführten Eingangssignals (IFI) über ein variables Phasenglied (PS) einem ersten Eingang eines Summierers (SU) zugeführt ist, einem zweiten Eingang des Summierers (SU) ein über einen Koppler (K2) ausgekoppelter Teil (S2) des Ausgangssignals (S2) des Verstärkers (HV) zugeführt ist, eine automatische Verstärkungsregelung (AGC) zur gegenseitigen Anpassung der Pegel der beiden an den Eingängen des Summierers (SU) anliegenden Signale (S1, S2) vorgesehen ist, das Ausgangssignal des Summierers (SU) zum einen als Regelgröße (RG) für das variable Phasenglied (PS) im Signalzweig dem Regler (R1) dieses Signalzweigs zugeführt ist, um das variable Phasenglied (PS) adaptiv so einzustellen, dass das Ausgangssignal des Summierers (SU) ausschließlich Intermodulationsprodukte enthält, und das Ausgangssignal des Summierers (SU) zum anderen als Regelgröße (RG) für die variablen Phasen- (PS3, PS5) und Dämpfungsglieder (DG3, DG5) des Vorverzerrers (VV) dem Regler (R2) der Schaltmittel zugeführt ist, **dadurch gekennzeichnet, dass** an den Ausgang des Summierers (SU) ein logarithmischer Verstärker (LV) geschaltet ist, der das die Intermodulationsprodukte enthaltende Ausgangssignal des Summierers (SU) in eine die Regelgröße (RG) bildende Gleichspannung wandelt.

2. Vorrichtung nach Anspruch 1, **dadurch gekennzeichnet, dass** das Eingangssignal (IFI) für den Vorverzerrer (VV) und den Signalzweig (LZ2, PS, D, AGC, SU, BS, LV, R1) in einem Zwischenfrequenzbereich liegt, dass dem Vorverzerrer (VV) ein Aufwärtsmischer (M1) nachgeschaltet ist, der das vorverzerrte Zwischenfrequenzsignal in die für den Hochfrequenzverstärker (HV) bestimmte Hochfrequenzebene heraufsetzt, und dass ein Abwärtsmischer (M2) den vom Verstärkerausgangssignal (RFO) ausgekoppelten Signalanteil (S2), aus dem die Regelgröße (RG) abgeleitet wird, in den Zwischenfrequenzbereich herabsetzt.

## Claims

1. A device for linearising a radio frequency amplifier by means of a pre-distorter (VV) connected before the amplifier (HV), comprising switching means including a regulator (R2) for the adaptive control of one or more variable phase members (PS3, PS5) and damping members (DG3, DG5) of the pre-distorter (VV) in dependence on the output signal (RFO) of the amplifier (HV) for the minimisation of the intermodulation products generated by the amplifier (HV), a signal branch (LZ2, PS, D, AGC, SU, BS, LV, R1) for the selection of the intermodulation products from the amplifier output signal (RFO) while including the input signal (IFI) of the pre-distorter (VV) and for the generation of a regulation parameter (RG) formed by the intermodulation products for the variable phase members (PS3, PS5) and damping members (DG3, DG5) of the pre-distorter (W), wherein a portion (S1) of the input signal (IFI), which is supplied to the pre-distorter (VV) and is decoupled in the signal branch via a coupler (K1), is supplied to a first input of a summer (SU) via a variable phase member (PS), a portion (S2) of the output signal (S2) of the amplifier (HV) decoupled via a coupler (K2) is supplied to a second input of the summer (SU), an automatic gain control (AGC) is provided for the mutual adaptation of the level of the two signals (S1, S2) applied to the inputs of the summer (SU), the output signal of the summer (SU) is supplied, on the one hand, as a regulation parameter (RG) for the variable phase member (PS) in the signal branch to the regulator (RI) of this signal branch to adaptively adjust the variable phase member (PS) such that the output signal of the summer (SU) only contains intermodulation products and the output signal of the summer (SU), on the other hand, is supplied as a regulation parameter (RG) for the variable phase members (PS3, PS5) and damping members (DG3, DG5) of the pre-distorter (VV) to the regulator (R2) of the switching means, **characterised in that** a logarithmic amplifier (LV) is connected to the output of the summer (SU) and converts the output signal of the summer (SU) including the intermodulation products into a DC voltage forming the regulation parameter (RG).

2. A device in accordance with claim 1, **characterised in that** the input signal (IFI) for the pre-distorter (VV) and the signal branch (LZ2, PS, D, AGC, SU, BS, LV, R1) is disposed in an intermediate frequency range; **in that** a step-up mixer (M1) is connected after the pre-distorter (VV) and steps up the pre-distorted intermediate frequency signal into the radio frequency plane determined for the radio frequency amplifier (HV); and **in that** a step-down mixer (M2) steps down into the intermediate frequency range the signal portion (S2) which is decoupled from the amplifier output signal (RFO) and from which the regulation parameter (RG) is derived.

## Revendications

1. Dispositif pour linéariser un amplificateur à haute fréquence au moyen d'un générateur de distorsion préliminaire (VV) disposé avant l'amplificateur (HV), comprenant des moyens de commutation, comprenant un régulateur (R2), pour la commande adaptative d'un ou plusieurs circuits variables de phase (PS3, PS5) et d'amortissement (DG3, DG5) du générateur de distorsion préliminaire (VV) en fonction du signal de sortie (RFO) de l'amplificateur (HV) pour minimiser les produits d'intermodulation générés par l'amplificateur (HV), une branche de signal (LZ2, PS, D, AGC, SU, BP, LV, R1) comprenant un régulateur (R1) pour la sélection des produits d'intermodulation hors du signal de sortie (RFO) de l'amplificateur en intégrant le signal d'entrée (IFI) du générateur de distorsion préliminaire (VV) et pour la génération d'une grandeur de régulation (RG), formée par les produits d'intermodulation, pour les circuits variables de phase (PS3, PS5) et d'amortissement (DG3, DG5) du générateur de distorsion préliminaire (VV), dans lequel, dans la branche de signal, une partie (S1), découplée au moyen d'un coupleur (K1), du signal d'entrée (IFI) admis au générateur de distorsion préliminaire (VV) est amenée via un circuit variable de phase (PS) à une première entrée d'un circuit de sommation (SU), une partie (S2) du signal de sortie (S2) de l'amplificateur (HV), découplée au moyen d'un coupleur (K2), est amenée à une seconde entrée du circuit de sommation (SU), il est prévu une régulation d'amplification automatique (AGC) pour l'adaptation réciproque des niveaux des deux signaux (S1, S2) appliqués aux entrées du circuit de sommation (SU), le signal de sortie du circuit de sommation (SU) est admis d'une part à titre de grandeur de régulation (RG) pour le circuit variable de phase (PS) dans la branche de signal, au régulateur (R1) de cette branche de signal, pour régler de façon adaptative le circuit variable de phase (PS) de telle façon que le signal de sortie du circuit de sommation (SU) contient exclusivement des produits d'intermodulation, et le signal de sortie du circuit de sommation (SU) est en outre admis à titre de grandeur de régulation (RG) pour les circuits variables de phase (PS3, PS5) et d'amortissement (DG3, DG5) du générateur de distorsion préliminaire (VV) au régulateur (R2) des moyens de commutation,
**caractérisé en ce qu'**un amplificateur logarithmique (LV) est branché à la sortie du circuit de sommation (SU), qui convertit le signal de sortie du circuit de sommation (SU) qui contient les produits d'intermodulation en une tension constante qui forme la grandeur de régulation (RG).

2. Dispositif selon la revendication 1, **caractérisé en ce que** le signal d'entrée (IFI) pour le générateur de distorsion préliminaire (VV) et la branche de signal (LZ2, PS, D, AGC, SU, BP, LV, R1) est situé dans une plage de fréquences intermédiaires, **en ce qu'**un mélangeur montant (M1) est branché après le générateur de distorsion préliminaire (VV), qui fait monter le signal à fréquence intermédiaire avec distorsion dans le plan à haute fréquence déterminé pour l'amplificateur à haute fréquence (HV), et **en ce qu'**un mélangeur descendant (M2) fait descendre la part de signal (S2) découplée depuis le signal de sortie de l'amplificateur (RFO), hors de laquelle la grandeur de régulation (RG) est dérivée, jusque dans la plage de fréquences intermédiaires.
